# EUROPEAN PATENT APPLICATION

(11) **EP 4 170 905 A1**
(43) Date of publication of application: **26.04.2023**
(21) Application number: 22198534.4
(22) Date of filing: 28.09.2022
(51) Int. Cl.: H03K 17/12, H03K 17/14, H01L 27/00

(54) **CIRCUIT COMPRISING A CASCODE DEVICE AND METHOD OF OPERATING CIRCUIT**

(30) Priority: 20.10.2021 US 202117505700
(71) Applicant: NXP B.V., 5656 AG Eindhoven (NL)
(72) Inventor: Swanenberg, Maarten Jacobus, 5656 AG Eindhoven (NL)
(74) Representative: Schmütz, Christian Klaus Johannes

(57) **Abstract**

A circuit comprising a cascode device comprising a field effect transistor. The field effect transistor includes a common body region. The field effect transistor also includes a plurality of source regions. The source regions form inputs of the cascode device. Each source region of the plurality of source regions is separated from each other source region of the plurality of source regions by the common body region. The field effect transistor further includes a common gate. The field effect transistor also includes a common drain region. The common drain region forms an output of the cascode device. The circuit may further include a plurality of groups of one or more current sources each group coupled to a respective one of the inputs of the cascode device, and a current output coupled to the output of the cascode device. A method of operating a current source circuit.

## Description

### BACKGROUND

The present specification relates to a circuit comprising a cascode device and to a method of operating a current source circuit.

In accurate digitally controlled current source circuits, each current source element may require a separate scaled cascode device. For current source circuits having a high voltage compatible output, these cascodes generally occupy a large area on a semiconductor die. To reduce the area occupied, often the currents from the separate current sources are combined before being inputted into a shared cascode device. However, this approach tends to compromise the linearity of the current source circuit.

### SUMMARY

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided a circuit comprising a cascode device, the cascode device including a field effect transistor comprising. The field effect transistor including a common body region and a plurality of source regions forming inputs of the cascode device. Each source region of the plurality of source regions is separated from each other source region of the plurality of source regions by the common body region. The field effect transistor including a common gate and a common drain region. The common drain region forms an output of the cascode device.

A circuit having cascode device according to this disclosure may occupy less space on a semiconductor die than some known cascode devices. Each source region may include a doped contact region located within the common body region. Each source region may include a respective doped contact region located within the common body region. Each source region may include a plurality of doped contact regions located within the common body region. The common gate may include a single gate electrode. The common gate may include a first gate electrode and a second gate electrode. The first gate electrode may be located between the common drain region and a first group of source regions of the plurality of source regions. The second gate electrode may be located between the common drain region and a second group of source regions of the plurality of source regions. The common gate, the common drain region and each of the plurality of source regions may each be provided with their own terminal. At least one source region of the plurality of source regions may be larger than at least one of the other source regions of the plurality of source regions. The cascode device may include a common drain drift region. The common drain drift region may be located between the common drain region and the common gate.

The circuit may further include a plurality of groups of one or more current sources, wherein each group of one or more current sources of the plurality of groups of current sources is coupled to a respective one of the inputs of the cascode device; and a current output coupled to the output of the cascode device. The current source circuit may further include digital control circuitry for selectively enabling/disabling the plurality of groups of one or more current sources. The digital control circuitry may be operable to apply a digital control word to the plurality of groups of one or more current sources to selectively enable/disable the groups of one or more current sources. The circuit may further include a cascode voltage source coupled to the common gate. Each source region may include a respective doped contact region located within the common body region. Each source region may include a plurality of doped contact regions located within the common body region. The common gate may include a single gate electrode.

The common gate may include a first gate electrode and a second gate electrode. The first gate electrode may be located between the common drain region and a first group of source regions of the plurality of source regions. The second gate electrode may be located between the common drain region and a second group of source regions of the plurality of source regions. The common gate, the common drain region and each of the plurality of source regions may each be provided with their own terminal. At least one source region of the plurality of source regions may be larger than at least one of the other source regions of the plurality of source regions. The circuit may include a common drain drift region. The common drain drift region may be located between the common drain region and the common gate.

According to a further aspect of the present disclosure, there is provided a method of operating a current source circuit, the method including selectively enabling/disabling a plurality of groups of one or more current sources, each group coupled to a respective input of a cascode device. The cascode device includes a field effect transistor that includes a common body region and a plurality of source regions forming the inputs of the cascode device. Each source region of the plurality of source regions is separated from each other source region of the plurality of source regions by the common body region. The field effect transistor includes a common gate and a common drain region. The common drain region forms an output of the cascode device, and wherein the output of the cascode device is coupled to a current output of the current source circuit.

The method may include selectively enabling/disabling the groups of one or more current sources by applying a digital control word to the groups of one or more current sources. The digital control word may include a plurality of bits. Each bit of the digital control word may be for selectively enabling/disabling a respective group of one of the current sources.

The cascode device, current source circuit and method may be implemented in a Controller Area Network (CAN) transceiver.

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows an example of a current source circuit;
Figure 2 shows another example of a current source circuit;
Figure 3 shows a further example of a current source circuit;
Figure 4 shows a current source circuit according to an embodiment of this disclosure;
Figure 5 shows a plan view of a cascode device according to an embodiment of this disclosure;
Figure 6 shows a cross section of a cascode device according to an embodiment of this disclosure; and
Figure 7 shows a method of operating a current source circuit according to an embodiment of this disclosure.

### DETAILED DESCRIPTION

Embodiments of this disclosure are described in the following with reference to the accompanying drawings.

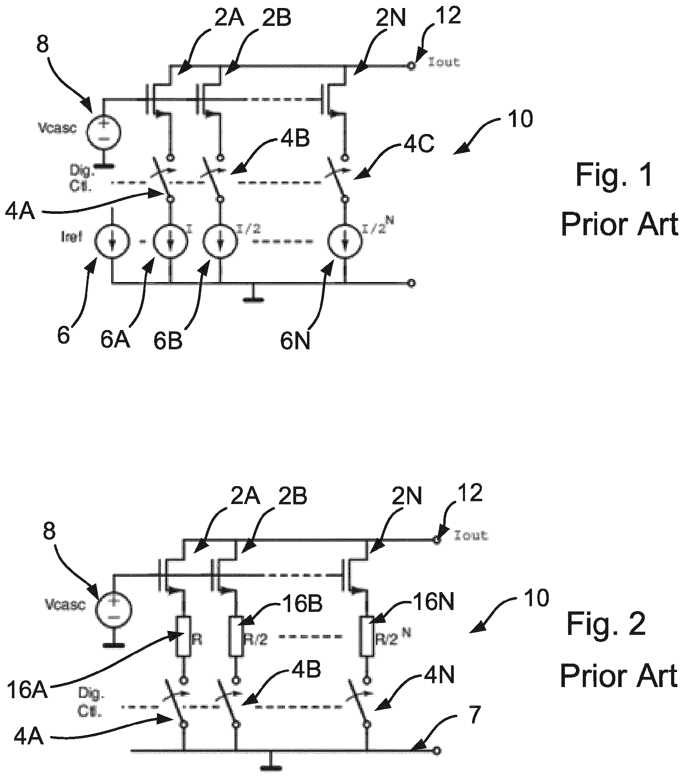

Figure 1 shows an example of a digitally controlled current source circuit 10. The digitally controlled current source circuit 10 includes a plurality of cascode devices 2A, 2B.... 2N. The cascode devices 2A, 2B.... 2N may be field effect transistors (FETs, e.g. Metal Oxide Semiconductor Field Effect Transistors (MOSFETs)). The digitally controlled current source circuit 10 also includes an output 12 for output a current Iₒᵤₜ. In this example, the drain of the field effect transistor forming each cascode device 2A, 2B.... 2N is coupled to the output 12.

The digitally controlled current source circuit 10 also includes a voltage source 8. The voltage source 8 is coupled to the gate of each field effect transistor forming each cascode device 2A, 2B.... 2N. The voltage source 8 may thus be used to apply a reference voltage (e.g. ground) to the gate of each field effect transistor forming each cascode device 2A, 2B.... 2N.

The digitally controlled current source circuit 10 also includes a plurality of current sources 6, 6A, 6B.... 6N. These current sources include a reference current source 6 and a plurality of further current sources 6A, 6B.... 6N. Each of the further current sources 6A, 6B.... 6N is coupleable to the source of a respective one of the field effect transistors forming the cascode devices 2A, 2B.... 2N by a respective switch 4A, 4B.... 4N. The switches 4A, 4B.... 4N are individually, digitally controllable for selectively coupling and decoupling the current sources to/from their respective cascode devices 2A, 2B.... 2N. The current sources are each configured to provide a respective current that is a fraction or multiple of the reference current I_{ref}. For example, as shown in Figure 1, the further current source 6A is configured to provide a current I, the further current source 6B is configured to provide a current I/2, and the final current source 6N is configured to provide a current I/(2^{N}). By individually and digitally controlling the switches 4A, 4B.... 4N (e.g. by applying a control word to the switches 4A, 4B.... 4N), the current output of the digitally controlled current source circuit 10 may be varied.

Figure 2 shows another example of a digitally controlled current source circuit 10. The digitally controlled current source circuit 10 is similar in some respects to the digitally controlled current source circuit 10 shown in Figure 1. However, in this example, the current sources are formed using a plurality of resistors 16A, 16B.... 16N, each of which is coupled to a respective one of the sources of the field effect transistors forming the cascode device 2A, 2B.... 2N. Each resistor 16A, 16B.... 16N has a resistance chosen to allow a respective amount of current to flow into the source of the field effect transistor forming the cascode device 2A, 2B.... 2N associated with that resistor 16A, 16B.... 16N. Each resistor 16A, 16B.... 16N is also selectively coupleable to a voltage rail 7 by a respective switch 4A, 4B.... 4N. As with the example shown in Figure 1, by individually and digitally controlling the switches 4A, 4B.... 4N (e.g. by applying a control word to the switches 4A, 4B.... 4N), the current output of the digitally controlled current source circuit 10 may thus be varied.

In a digitally controlled current source circuit 10 of the kind shown in Figures 1 and 2, the current sources driving the output are each provided with a respective cascode device to reduce their sensitivity to the voltage on the output terminal. Because high accuracy may be needed, each current source is provided with a respective cascode device. In regular circuitry, the cascode devices and the current sources may be of comparable size. However, for circuits requiring a high-voltage tolerant output (e.g. Controller Area Network (CAN) transceivers), the area on a semiconductor die that is occupied by the field effect transistor forming each cascode device scales quadratically with the output voltage and thus may become much larger than the area occupied by the current sources.

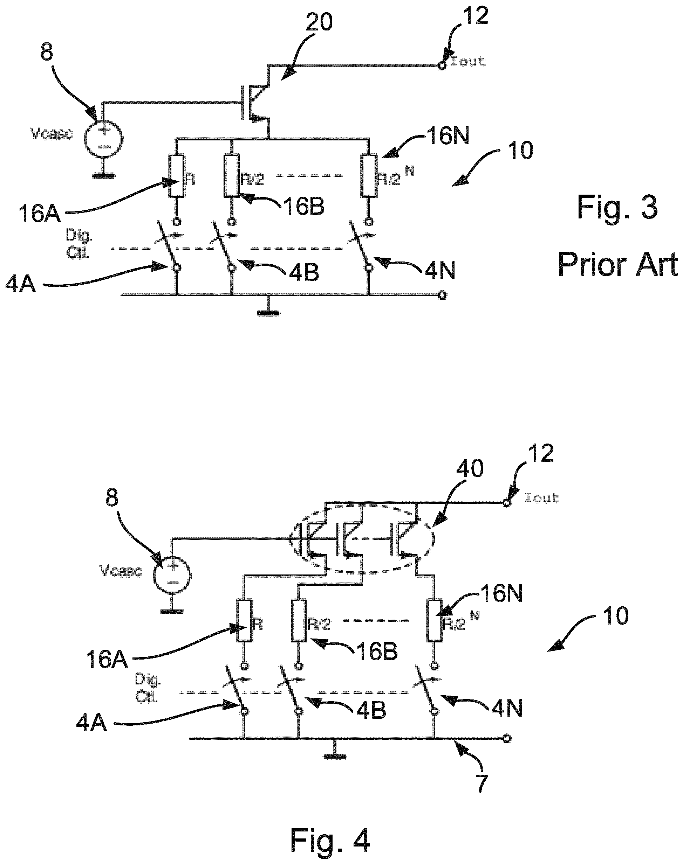

Figure 3 shows a further example of a digitally controlled current source circuit 10. The digitally controlled current source circuit 10 in this example is similar to the example shown in Figure 2. However, in this example, the cascode devices 2A, 2B.... 2N described above are replaced by a single, shared cascode device 20. The shared cascode device 20 comprises a field effect transistor (e.g. a MOSFET). The source of the shared cascode device 20 coupled to each of the resistors 16A, 16B.... 16N, and the drain of the shared cascode device is coupled to the output 12.

The digitally controlled current source circuit 10 in Figure 3 dispenses with multiple cascodes devices, instead to use a single, shared cascode device 20, so as to reduce the overall space occupied on a semiconductor die. Thus, the currents from the separate current sources are combined before being inputted into the shared cascode device 20. However, this approach tends to compromise the linearity of the digitally controlled current source circuit 10. Similar considerations would apply to a digitally controlled current source circuit of the kind shown in Figure 1, using a shared cascode device.

Figure 4 shows a digitally controlled current source circuit 10 according to an embodiment of this disclosure. The digitally controlled current source circuit 10 includes a shared of cascode device 40, which comprises a field effect transistor, which will be described in more detail below.

The digitally controlled current source circuit 10 also includes an output 12 for output a current Iₒᵤₜ. The drain of the field effect transistor forming the shared cascode device 40 is coupled to the output 12 of the digitally controlled current source circuit 10.

The digitally controlled current source circuit 10 also includes a voltage source 8. The voltage source 8 is coupled to the gate of the field effect transistor forming the shared cascode device 40. The voltage source 8 may thus be used to apply a reference voltage (e.g. ground) to the gate of the field effect transistor forming the shared cascode device 40.

The digitally controlled current source circuit 10 also includes a plurality of current sources. In this embodiment, the current sources are formed by a plurality of resistors 16A. 16B.... 16N coupleable to a voltage rail 7 via a plurality of respective switches 4A, 4B.... 4N. Each resistor 16A, 16B.... 16N has a resistance chosen to allow a respective amount of current to flow into the field effect transistor forming the shared cascode device 40. By individually and digitally controlling the switches 4A, 4B.... 4N (e.g. by applying a control word to the switches 4A, 4B.... 4N), the current output of the digitally controlled current source circuit 10 may thus be varied. This part of the circuit is therefore similar to the current source arrangement shown in Figure 2.

In another embodiment, the current source portion of the digitally controlled current source circuit 10 may be configured as described above in relation to Figure 1. Thus, the current sources may include a reference current source 6 and a plurality of further current sources 6A, 6B.... 6N. Each of the further current sources 6A, 6B.... 6N may be coupleable to the source of the field effect transistor forming the shared cascode device 40 by a respective switch 4A, 4B.... 4N. The switches 4A, 4B.... 4N may be individually, digitally controllable for selectively coupling and decoupling the current sources to/from the shared cascode device 40. The current sources may each configured to provide a respective current that is a fraction or multiple of the reference current I_{ref}, in much the same way as described above in respect of Figure 1. By individually and digitally controlling the switches 4A, 4B.... 4N (e.g. by applying a control word to the switches 4A, 4B.... 4N), the current output of the digitally controlled current source circuit 10 may be varied.

Returning to Figure 4, the shared cascode device 40 has multiple inputs. In particular, the shared cascode device 40 comprises a field effect transistor having a plurality of source regions, each of which may form a respective one of the inputs of the shared cascode device 40. In this embodiment, each of the current sources of the digitally controlled current source circuit 10 is coupled to a respective one of the inputs of the shared cascode device 40. For instance, each current source may be coupled to a respective one of the source of the field effect transistor forming the shared cascode device 40. In the embodiment of Figure 4, this may be implemented by coupling each of the resistors 16A, 16B.... 16N to a respective one of the sources of the field effect transistor forming the shared cascode device 40. In embodiments in which the current source arrangement is similar to that shown in Figure 1, this may instead be implemented by coupling a respective one of the further current sources 6A, 6B.... 6N to each of the sources of the field effect transistor forming the shared cascode device 40, via a respective one of the switches 4A, 4B.... 4N.

It is also envisaged that in some embodiments, to increase the current that may be supplied to each input of the shared cascode device 40, a plurality of groups of current sources may be provided, each group including one or more parallel-coupled current sources. Each group may be coupled to a respective input of the shared cascode device 40. The arrangement shown in Figure 4 may be viewed as an embodiment in which each "group" includes a single current source.

On the other hand, the field effect transistor forming the shared cascode device 40 has a shared (e.g. single) drain region, which forms an output of the shared cascode device 40. The output of the shared cascode device 40 is coupled to the output 12 of the digitally controlled current source circuit 10.

Accordingly, the shared cascode device 40 may have a shared high-voltage tolerant output and multiple inputs. The shared high voltage tolerant output may allow an area saving to be made relative to the examples shown in Figures 1 and 2. On the other hand, the multiple inputs of the cascode device 40 may be scaled separately, to provide each group of one or more current sources with its own dedicated and optimized cascode input. In contrast to the example of Figure 3, sharing of the cascode device 40 may thus be achieved in a manner which need not have an adverse effect on the linearity of the digitally controlled current source circuit 10.

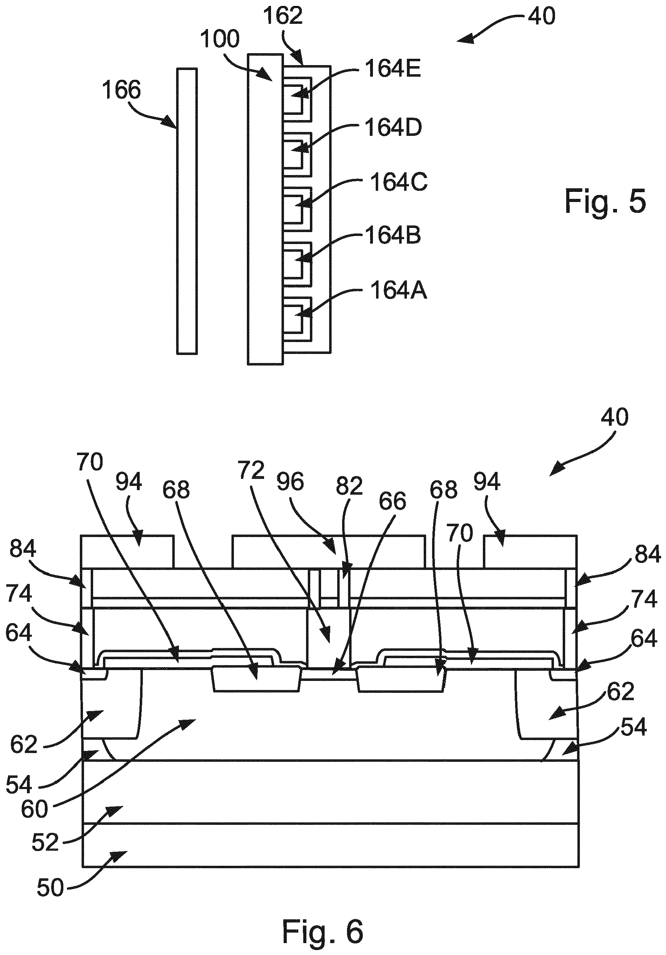

Figure 5 shows a plan view of a cascode device 40 according to an embodiment of this disclosure. The cascode device 40 may be used in a current source circuit 10 of the kind shown in Figure 4.

The cascode device 40 includes a field effect transistor. The field effect transistor may be provided on a semiconductor substrate comprising, for example silicon. In some embodiments, the semiconductor substrate may be a silicon on insulator (SOI) substrate. The field effect transistor may be an NMOS or a PMOS field effect transistor.

The field effect transistor includes a common gate 100. The field effect transistor also includes a common drain 166. The common drain 166 is provided on a first side of the common gate 100. A common drain drift region may be located between the common drain region 166 and the common gate 100 although other embodiments would not include a drift region.

The field effect transistor further includes a plurality of source regions 164A, 164B, 164C, 164D, 164E. In the present embodiment, there are five source regions, but it is envisaged that any number of source regions may be provided, in accordance with the granularity of the current profile to be provided by a current source circuit 10 incorporating the cascode device 40. The plurality of source regions 164A, 164B, 164C, 164D, 164E are provided on a second side of the common gate 100, opposite the common drain 166. The field effect transistor also includes a common body region 162.

The common drain region 162, the common gate 100 and each of the plurality of source regions 164A, 164B, 164C, 164D, 164E may be provided with their own terminal.

The common gate 100 in the present embodiment is elongate, so as to provide space for the multiple source regions164A, 164B, 164C, 164D, 164E. The common drain 166 may also be elongate (having a long dimension substantially parallel to a long dimension of the common gate 100) so as to avoid current crowding. Other layouts for the common gate 100 and other features such as the common drain 166 and plurality of source regions 164 are envisaged. For instance, the common gate 100 may be in the form of a loop or "racetrack" when viewed from above the substrate, with the common drain 166 located inside the loop and the plurality of source regions 164 located outside the loop (or vice versa).

Each of the plurality of source regions 164A, 164B, 164C, 164D, 164E forms an input of the cascode device 40. Thus, in a current source circuit 10 of the kind described above, the groups of one or more current sources may be coupled to the plurality of source regions 164A, 164B, 164C, 164D, 164E. In some embodiments, there may be a one-to-one mapping between the groups of current sources of the current source circuit 10 and the plurality of source regions 164A, 164B, 164C, 164D, 164E. In other words, each group of one or more current source of the current source circuit 10 may be coupled to a single, respective source region 164A, 164B, 164C, 164D, 164E of the cascode device 40. Nevertheless, it is envisaged that in other embodiments, some (or all) of the groups of one or more current sources of the current source circuit 10 may be connected to more than one of the source regions 164A, 164B, 164C, 164D, 164E. This may allow large current sources to be used, without risking device breakdown within the field effect transistor. Nevertheless, even in such embodiments, no source region 164A, 164B, 164C, 164D, 164E of the cascode device 40 would be coupled to multiple groups of (e.g. parallel-coupled) current sources of the current source circuit 10. That is to say, each group of one or more current sources of the current source circuit 10 is coupled to its own respective set of one or more source regions 164A, 164B, 164C, 164D, 164E of the cascode device 40.

The common drain 166 forms an output of the cascode device 40 and may be coupled to the output 12 of the current source circuit 10.

As can be seen in the plan view of Figure 5, each source region of the plurality of source regions 164A, 164B, 164C, 164D, 164E is separated from each other source region of the plurality of source regions 164A, 164B, 164C, 164D, 164E by the common body region 162. The common body region 162 may comprise a semiconductor region in the semiconductor substrate or die in which the field effect transistor is formed. The semiconductor region may be doped. The plurality of source regions 164A, 164B, 164C, 164D, 164E may comprise semiconductor regions (e.g. doped contact regions) formed within the common body region 162 and, in some embodiments, be more highly doped than the common body region. The common body region 162 may thus at least partially surround each of the plurality of source regions 164A, 164B, 164C, 164D, 164E when viewed from above a major surface of the substrate or die (as seen in Figure 5), thereby to separate the plurality of source regions 164A, 164B, 164C, 164D, 164E from each other. The common body region 162 may also extend beneath each of the plurality of source regions 164A, 164B, 164C, 164D, 164E. Each of the plurality of source regions 164A, 164B, 164C, 164D, 164E may be viewed as a separate island, located within the common body region 162. The net conductivity doping of the source regions 164A, 164B, 164C, 164D, 164E and the common drain 166 may be of a different conductivity type to the common body region 162. For instance, the source regions 164A, 164B, 164C, 164D, 164E and the common drain 166 may have n-type conductivity and the common body region 162 may have p-type conductivity. The source regions 164A, 164B, 164C, 164D, 164E and the common drain 166 may also be more highly doped than the common body region 162.

In operation, current may flow from each of the plurality of source regions 164A, 164B, 164C, 164D, 164E to the common drain region 166 via a channel region beneath the common gate 100, according to whether or not the current sources of the current source circuit 10 are presently enabled. Thus, the cascode device 40 may provide a single device that may be used in place of the multiple devices 2A, 2B... 2N shown in, for example, Figures 1 and 2. This may reduce the amount of space required on a semiconductor substrate or die for implementing the current source circuit 10. Moreover, the cascode device 40 may not compromise the linearity of the current source circuit 10 in the way described above in relation to the cascode device 20 of Figure 3.

It is also envisaged that the number and configuration (e.g. shape, size) plurality of source regions 164A, 164B, 164C, 164D, 164E may be scaled and tailored to the number of (groups of) current sources in the current source circuit 10 and the current capabilities of those current sources. For instance, the cascode device 40 may include differently sized source regions. Larger source regions of the cascode device 40 may be coupled to (groups of) current sources that are configured to supply a larger amount of current, while smaller source regions of the cascode device 40 may be coupled to (groups of) current sources that are configured to supply a smaller amount of current.

Figure 6 shows a cross section of a cascode device 40 according to an embodiment of this disclosure. The cascode device 40 may be used in a current source circuit 10 of the kind shown in Figure 4. Note that the layout of the cascode device 40 in Figure 6 differs from that shown in Figure 5 in some respects (e.g. the cascode device 40 includes a pair of gate electrodes 70, which are coupled together to form a common gate). This will be explained in more detail below.

The cascode device 40 includes a semiconductor substrate 50 (e.g. Silicon). In this embodiment, the cascode device 40 is implemented using Silicon on Insulator (SOI) technology and the substrate 50 is provided with a buried oxide layer 52 covered with an epitaxial semiconductor layer (e.g. silicon) 54. The epitaxial layer 54 in this embodiment is p-type doped.

The cascode device 40 also includes a drift region 60, which is n-type doped in this embodiment. The drift region 60 may be formed by doping (e.g. by ion implantation) of the epitaxial layer 54 to form an n-type well.

The cascode device 40 in this embodiment includes p-type doped common body regions 62, which are provided at the lateral regions of the device 40. The common body regions 62 may be formed by doping (e.g. by ion implantation) the lateral regions of the device 40 to form p-type doped wells.

The cascode device 40 in this embodiment further includes source regions 64. The source regions 64 are located within the common body regions 62. In this embodiment, the source regions are n-type doped, e.g. by ion implantation, to form doped contact regions. As described above, the source regions 64 form inputs of the cascode device 40. Although not visible in the cross section view of Figure 6, the source regions 64 on either side of the device 40 may be provided in a linear row much like the source regions shown in Figure 5. In this way, the device 40 may include multiple source regions 64 located in a common body region 62 on either lateral side of the device 40.

The cascode device 40 in this embodiment further includes a common drain region 66. Like the source regions 64, the common drain region 66 may be n-type doped, e.g. by ion implantation. As described above, the common drain region 66 forms an output of the cascode device 40.

The cascode device 40 also includes a common gate, which in this embodiment is formed using two gate electrodes 70. The gate electrodes 70 are provided on the surface of the drift region 60 (with an intervening gate dielectric, which is not shown in Figure 6). The gate electrodes 70 are located on either side of the common drain region 66 in this embodiment, between the common drain region 66 and the source regions 64. The gate electrodes 70 may, for instance, comprise polysilicon.

Insulation regions 68 (e.g. shallow trench isolation (STI)) may be provided on either side of the common drain region 66, partially underlying the gate electrodes 70.

The source regions 64, common drain region 66 and common gate 70 may be provided with local interconnects 74, 84, 72, 82 (gate interconnect not shown in Figure 6) leading to metal contacts 94, 96 (gate contact not shown in Figure 6) to provide terminals for making appropriate electrical connections to the device 40. Note that the gates 70 may be connected together in this arrangement to form a common gate.

It is envisaged that the interconnects 74, 84 may be configured such that each source region of the device 40 corresponds to a respective one of the doped contact regions 64. However, it is also envisaged that the interconnects 74, 84 may be configured such that each each source region comprises a plurality of the doped contact regions 64, which may increase the current rating of the device 40. In such embodiments, the interconnects 74, 84 may connect groups of the doped contact regions 64 (each group including more than one doped contact region 64) to a respective metal contact 94. In this way, the device 40 may include a plurality of source regions, each having multiple doped contact regions 64 connected to one of the metal contacts 94. Note that in such embodiments, each source region is separated from each other source region by the common body region 64, because all of the doped contact regions 64 are themselves separated from each other by the common body region 64.

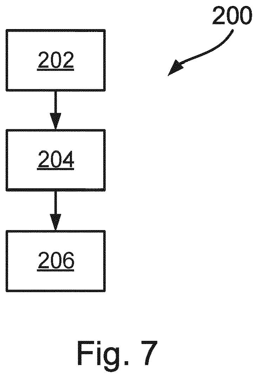

Figure 7 shows a method 200 of operating a current source circuit according to an embodiment of this disclosure. The method 200 may begin in step 202, with the provision of a current source circuit 10 of the kind described above in relation to Figure 4. The cascode device 40 included in the current source circuit 10 may, for instance, be a cascode device 40 of the kind described in relation to either Figure 5 or Figure 6.

In a next step 204, the current source circuit 10 may be initialised by using the voltage source 8 to apply a cascode voltage/potential to the gate terminal 100 of the field effect transistor forming the cascode device 40. This initialisation step 204 may also include initialising the (groups of) current sources, for example by enabling the voltage rail 7 and or turning on the current sources 6A, 6B... 6N and the reference current source 6.

In a next step 206, one or more (groups of) current sources of a plurality of current sources coupled to respective inputs of a cascode device 40 may be enabled/disabled, in order to supply a desired current to the output 12 of the current source circuit 10 via the cascode device 40. Where the current sources are of the kind shown in Figure 4, the enabling/disabling of the current sources may involve selectively opening and closing the switches 4A, 4B... 4N to provide the appropriate amount of current to the respective inputs (source regions) of the cascode device 40 via the resistors 16A, 16B... 16N. Where the current sources are of the kind shown in Figure 1, the enabling/disabling of the current sources may involve selectively opening and closing the switches 4A, 4B... 4N to provide the appropriate amount of current to the respective inputs (source regions) of the cascode device 40 from the current sources 6A, 6B...6N.

Step 206 may involve selectively enabling/disabling the (groups of) one or more current sources by applying a digital control word to the plurality of current sources. The current source circuit 10 may include digital control circuitry connected to the switches 4A, 4B... 4N for the application of the digital control word to those switches 4A, 4B... 4N. The digital control word may comprise a plurality of bits. Each bit of the control word may be coupled to a respective one of the switches 4A, 4B... 4N for selectively controlling that respective switch 4A, 4B... 4N. In some embodiments, the switches may comprise transistors, and the control terminal (e.g. gate, base) of each transistor may be coupled to receive a respective bit of the control word that corresponds to a control voltage/potential which either switches on, or turns off that transistor, thereby to close or open the switch.

Accordingly, there has been described a circuit comprising a cascode device comprising a field effect transistor. The field effect transistor includes a common body region. The field effect transistor also includes a plurality of source regions. The source regions form inputs of the cascode device. Each source region of the plurality of source regions is separated from each other source region of the plurality of source regions by the common body region. The field effect transistor further includes a common gate. The field effect transistor also includes a common drain region. The common drain region forms an output of the cascode device. The circuit may further include a plurality of groups of one or more current sources each group coupled to a respective one of the inputs of the cascode device, and a current output coupled to the output of the cascode device. A method of operating a current source circuit.

Although particular embodiments of this disclosure have been described, it will be appreciated that many modifications/additions and/or substitutions may be made within the scope of the claims.

## Claims

1. A circuit comprising a cascode device, the cascode device comprising:
a field effect transistor comprising:
a common body region;
a plurality of source regions forming inputs of the cascode device, wherein each source region of the plurality of source regions is separated from each other source region of the plurality of source regions by the common body region;
a common gate; and
a common drain region, wherein the common drain region forms an output of the cascode device.

2. The circuit of claim 1, wherein each source region comprises a doped contact region located within the common body region.

3. The circuit of claim 2, wherein each source region comprises a respective doped contact region located within the common body region.

4. The circuit of claim 2, wherein each source region comprises a plurality of doped contact regions located within the common body region.

5. The circuit of any of claims 1 to 4, wherein the common gate comprises a single gate electrode.

6. The circuit of any of claim 1 to 4, wherein the common gate comprises a first gate electrode and a second gate electrode, wherein the first gate electrode is located between the common drain region and a first group of source regions of the plurality of source regions, and wherein the second gate electrode is located between the common drain region and a second group of source regions of the plurality of source regions.

7. The circuit of any of claims 1 to 6, wherein the common gate, the common drain region and each of the plurality of source regions are each provided with their own terminal.

8. The circuit of any of claims 1 to 7, wherein at least one source region of the plurality of source regions is larger than at least one of the other source regions of the plurality of source regions.

9. The circuit of any of claims 1 to 8, comprising:
a plurality of groups of one or more current sources, wherein each group of one or more current sources of the plurality of groups of current sources is coupled to a respective one of the inputs of the cascode device; and
a current output coupled to the output of the cascode device.

10. The circuit of claim 9, further comprising digital control circuitry for selectively enabling/disabling the plurality of groups of one or more current sources.

11. The circuit of claim 10, wherein the digital control circuitry is operable to apply a digital control word to the plurality of groups of one or more current sources to selectively enable/disable the groups of one or more current sources.

12. The circuit of any of claims 9 to 11, further comprising a cascode voltage source coupled to the common gate.

13. The circuit of claim 9, wherein each source region comprises a respective doped contact region located within the common body region.

14. The circuit of claim 9, wherein each source region comprises a plurality of doped contact regions located within the common body region.

15. A method of operating a current source circuit, the method comprising:
selectively enabling/disabling a plurality of groups of one or more current sources, each group coupled to a respective input of a cascode device, wherein the cascode device comprises:
a field effect transistor comprising:
a common body region;
a plurality of source regions forming the inputs of the cascode device, wherein each source region of the plurality of source regions is separated from each other source region of the plurality of source regions by the common body region;
a common gate; and
a common drain region, wherein the common drain region forms an output of the cascode device, and wherein the output of the cascode device is coupled to a current output of the current source circuit.
